(19) Europäisches Patentamt
European Patent Office
Office européen des brevets

(11) **EP 3 296 757 B1**

(12) **EUROPÄISCHE PATENTSCHRIFT**

(45) Veröffentlichungstag und Bekanntmachung des Hinweises auf die Patenterteilung:
**04.09.2024 Patentblatt 2024/36**

(21) Anmeldenummer: **17165569.9**

(22) Anmeldetag: **07.04.2017**

(51) Internationale Patentklassifikation (IPC):
**G01R 33/48** (2006.01)   **G01R 33/56** (2006.01)

(52) Gemeinsame Patentklassifikation (CPC):
**G01R 33/4818;** G01R 33/4806

(54) **ARTEFAKTARME MAGNETRESONANZ-FINGERPRINTING-MESSUNG**

LOW ARTEFACT MAGNETIC RESONANCE FINGERPRINTING MEASUREMENT

MESURE D'EMPREINTE DIGITALE PAR RÉSONANCE MAGNÉTIQUE SANS ARTÉFACT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.09.2016 DE 102016217675**

(43) Veröffentlichungstag der Anmeldung:
**21.03.2018 Patentblatt 2018/12**

(73) Patentinhaber: **Siemens Healthineers AG**
**91301 Forchheim (DE)**

(72) Erfinder:
• **Kluge, Thomas**
**96114 Hirschaid (DE)**
• **Körzdörfer, Gregor**
**91058 Erlangen (DE)**
• **Nittka, Mathias**
**91083 Baiersdorf (DE)**

(74) Vertreter: **Siemens Healthineers**
**Patent Attorneys**
**Postfach 22 16 34**
**80506 München (DE)**

(56) Entgegenhaltungen:
• **JEFFREY TSAO ET AL: "Lattice permutation for reducing motion artifacts in radial and spiral dynamic imaging", MAGNETIC RESONANCE IN MEDICINE., vol. 55, no. 1, 1 January 2006 (2006-01-01), US, pages 116 - 125, XP055435464, ISSN: 0740-3194, DOI: 10.1002/mrm.20743**

• **DAN MA ET AL: "Magnetic resonance fingerprinting", NATURE, vol. 495, no. 7440, 13 March 2013 (2013-03-13), pages 187 - 192, XP055183037, ISSN: 0028-0836, DOI: 10.1038/nature11971**

• **WANG ZHE ET AL: "Magnetic Resonance Fingerprinting with compressed sensing and distance metric learning", NEUROCOMPUTING, vol. 174, 21 October 2015 (2015-10-21), pages 560 - 570, XP029328329, ISSN: 0925-2312, DOI: 10.1016/J.NEUCOM.2015.09.077**

• **JOSEF PFEUFFER ET AL.: "Mitigation of Spiral Undersampling Artifacts in Magnetic Resonance Fingerprinting (MRF) by Adapted Interleave Reordering", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, no. 133, 7 April 2017 (2017-04-07), XP040687701**

• **GREGOR KÖRZDÖRFER ET AL.: "Spatial biases in Magnetic Resonance Fingerprinting parameter maps arising from undersampling patterns", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, no. 3956, 7 April 2017 (2017-04-07), XP040691524**

• **ALESSANDRO SBRIZZI ET AL.: "Dictionary-free MR Fingerprinting with low-pass balanced-GRE sequences", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, no. 932, 7 April 2017 (2017-04-07), XP040688500**

- **KÖRZDÖRFER GREGOR ET AL: "Effect of spiral undersampling patterns on FISP MRF parameter maps", MAGNETIC RESONANCE IMAGING, ELSEVIER SCIENCE, TARRYTOWN, NY, US, vol. 62, 15 January 2019 (2019-01-15), pages 174 - 180, XP085758389, ISSN: 0730-725X, [retrieved on 20190115], DOI: 10.1016/J.MRI.2019.01.011**

**Beschreibung**

Die Erfindung betrifft Verfahren zur Reduzierung von Artefakten in mittels Magnetresonanz-Fingerprinting erstellten Parameterkarten.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einer Magnetresonanzanlage in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar.

Eine Magnetresonanz-Bildgebung mittels einer Magnetresonanzanlage kann dazu dienen, eine Anwesenheit und/oder eine Verteilung eines Stoffs, welcher sich in einem Untersuchungsobjekt befindet, zu bestimmen. Der Stoff kann dabei beispielsweise ein, möglicherweise pathologisches, Gewebe des Untersuchungsobjekts, ein Kontrastmittel, eine Markierungssubstanz oder ein Stoffwechselprodukt sein.

Informationen über die vorliegenden Stoffe können dabei auf vielfältige Weise aus den aufgenommenen Messdaten gewonnen werden. Eine relativ einfache Informationsquelle sind z.B. aus den Messdaten rekonstruierte Bilddaten. Diese in der klinischen Routine meist verwendeten konventionellen Sequenzen erzeugen lediglich eine relative Signalintensität unterschiedlicher Gewebetypen (sogenannte Wichtungen), so dass die diagnostische Interpretation in hohem Maße der subjektiven Einschätzung des Radiologen unterliegt.

Ein Verfahren zur Bestimmung einer Reihenfolge von Segmenten von im Rahmen einer dynamischen MR-Bildgebung verwendeten k-Raumtrajektorien ist aus dem Artikel von Tsao et al. "Lattice Permutation for Reducing Motion Artifacts in Radial and Spiral Dynamic Imaging", Magn. Reson. Med. 55: S. 116-125 (2006) bekannt.

Im Gegensatz dazu lassen sich mit Hilfe von quantitativen MR Bildgebungstechniken absolute Eigenschaften des gemessenen Untersuchungsobjekts bestimmen, am Menschen z.B. insbesondere die gewebespezifische T1-und T2-Relaxation z.B. als Parameterkarten, die die Parameterwerte, die jeweiligen Relaxationszeiten, räumlich aufgelöst wiedergeben. Quantitative Techniken bieten somit den offensichtlichen Vorteil einer objektiven Vergleichbarkeit, finden aber aufgrund langer Messzeiten derzeit in der Routine kaum Verwendung.

Mit Hilfe neuer Messverfahren wie Magnetresonanz-Fingerprinting-Verfahren (MRF-Verfahren) könnte der Nachteil der langen Messzeiten auf ein akzeptables Maß gesenkt werden. Das Prinzip dieser Methode ist es durch pseudo zufällige Variation von Sequenzparametern (Flipwinkel, TR, Gradienten,...) möglichst unterschiedliche Signalverläufe für verschiedene Substanzen zu erzeugen und diese mit einer Vielzahl im Voraus simulierter Signalverläufe zu vergleichen. Die Gesamtheit der im Voraus simulierten Signale wird als "Dictionary" bezeichnet. Simuliert werden Signalverläufe für verschiedene Kombinationen aus T1- und T2-Relaxationszeiten bzw. der gewünschten Gewebe-Parameter. Die Parameterwerte eines Bildpunktes (Pixels, bzw. Voxels) im Bild werden bestimmt, indem der gemessene Signalverlauf mit allen simulierten Signalverläufen verglichen wird. Dieser Vorgang wird als "Matching" bezeichnet. Derjenige simulierte Verlauf der dem gemessenen am ähnlichsten ist, determiniert die Relaxationsparameter, z.B. T1 und T2, des Pixels.

Magnetresonanz-Fingerprinting-Verfahren sind beispielsweise in dem Artikel von Ma et al., "Magnetic Resonance Fingerprinting", Nature, 495: S. 187-192 (2013) und in dem Artikel von Jiang et al., ""MR Fingerprinting Using Fast Imaging with Steady State Precession (FISP) with Spiral Readout", Magnetic Resonance in Medicine 74: S. 1621-1631 (2015) oder auch in dem Artikel von Wang et al. "Magnetic resonance fingerprinting with compressed sensing and distance metric learning", Neurocomputing 174: S. 560-570 (2016), beschrieben.

Für MRF-Verfahren kann grundsätzlich jede Echotechnik in Kombination mit jeglichem Verfahren zur k-Raum-Abtastung (kartesisch, Spirale, radial) zur Aufnahme der Messdaten benutzt werden.

In dem genannten Artikel von Jiang et al. wird ein MRF-Verfahren beschrieben, bei dem eine FISP ("Fast Imaging with Steady State Precession")-Sequenz verwendet wird, die 1000 Mal unter Variation der Wiederholzeit TR und des Flipwinkels wiederholt wird, wobei bei jeder Wiederholung Messdaten entlang einer spiralförmigen k-Raum-Trajektorie aufgenommen werden. In dem beschriebenen Verfahren werden 24 Wiederholungen benötigt, um das k-Raum-Zentrum mit der k-Raum-Trajektorie gemäß Nyquist vollständig abzutasten und sogar 48 Wiederholungen, um insgesamt eine Auflösung von 256*256 zu erreichen, bei der auch der periphere k-Raumbereich gemäß Nyquist vollständig abgetastet ist. Die verwendete k-Raum-Trajektorie wird daher in jeder Wiederholung um einen Winkelschritt von 360°/48 = 7,5° rotiert. Ein Messdatensatz einer Wiederholung, aus dem Bilddaten rekonstruiert werden, ist somit 48-fach unterabgetastet. Daher weisen die rekonstruierten Bilddaten, aus denen die mit der Datenbank zu vergleichenden Bildpunkt-Zeit-Serien erstellt werden, starke Unterabtastungs-Artefakte auf. Obwohl Jiang et al. in dem Artikel schließen, dass diese Unterabtastungsartefakte sich insgesamt herausmitteln und daher keinen Einfluss auf die Parameterkarten haben, die als Ergebnisse des Vergleichs mit der Datenbank erhalten werden, können doch räumliche fehlerhafte Abweichungen /Verschiebungen ("spatial bias"), die auch als Shading-Artefakte bezeichnet werden, in den Parameterkarten auftreten.

Die Nutzung von k-Raumtrajektorien mit hohen Unterabtastungsraten ist ein zentraler Bestandteil für eine zeiteffiziente Implementierung quantitativer MR-Verfahren wie MRF. Negative Auswirkungen in Form von Artefakten, die aus dieser Unterabtastung resultieren sind daher problematisch. In der nachveröffentlichten DE102016217675 ist bereits beschrieben, wie grundsätzlich die Auswirkungen derartiger Unterabtastungsartefakte in durch MR-Fingerprinting erzeugten Parameterkarten eines Untersuchungsobjektes reduziert werden können. Die genauen Ursachen und Abhängigkeiten, die zur Entstehung bzw. Vermeidung dieser Fehler führen, sind noch unverstanden.

Der Erfindung liegt die Aufgabe zugrunde, die genannten Artefakte insbesondere in mittels MR-Fingerprinting erstellten Parameterkarten zu vermeiden bzw. zu reduzieren.

Die Aufgabe wird gelöst durch ein Verfahren zur Bestimmung einer bevorzugten Reihenfolge von N k-Raum-trajektorien, entlang welcher in der bevorzugten Reihenfolge nacheinander jeweils ein unterabgetasteter Messdatensatz für eine Magnetresonanz-Fingerprinting-Messung gemessen werden soll gemäß Anspruch 1, eine Magnetresonanzanlage gemäß Anspruch 12, ein Computerprogrammprodukt gemäß Anspruch 13 und einen elektronisch lesbaren Datenträger gemäß Anspruch 14.

Ein erfindungsgemäßes Verfahren zur Bestimmung einer bevorzugten Reihenfolge von N k-Raumtrajektorien, entlang welcher (in der bevorzugten Reihenfolge nacheinander) jeweils ein unterabgetasteter Messdatensatz für eine Magnetresonanz-Fingerprinting(MRF)-Messung gemessen werden kann umfasst die Schritte:

- Wählen eines Abtastschemas, welches N k-Raumtrajektorien umfasst, entlang derer Messdaten derart aufgenommen werden können, dass aus den entlang mindestens einer der N k-Raum-trajektorien gemessenen Messdaten ein gemäß Nyquist unterabgetasteter Messdatensatz erstellt werden kann, wobei aus aus den unterabgetasteten Messdatensätzen rekonstruierten Bildpunkten ein Signalverlauf mindestens eines aus dem unterabgetasteten Messdatensatz rekonstruierten Bildpunktes ermittelt werden kann, und aus den ermittelten Signalverläufen durch Vergleichen der ermittelten Signalverläufe mit einer Vergleichsregel ein Parameter des Untersuchungsobjekts pro rekonstruiertem Bildpunkt bestimmt werden kann,
- Variieren einer Reihenfolge in welcher die N k-Raumtrajektorien zeitlich nacheinander abgetastet werden sollen, sodass zumindest zwei unterschiedliche Reihenfolgen entstehen,
- Vergleichen von entsprechend der durch die Variation entstandenen Reihenfolgen ermittelten Test-Signalverläufen mit idealen Signalverläufen, wobei die idealen Signalverläufe aus Vergleichs-Signalverläufen eines Dictionarys eines (MRF)-Verfahrens bestimmt werden,
- Bestimmen einer bevorzugten Reihenfolge aus den entstandenen Reihenfolgen, mit der Artefakte in mittels MRF ermittelten Parameterkarten vermieden oder zumindest reduziere werden können, unter Berücksichtigung der Ergebnisse des Vergleichens.

Das erfindungsgemäße Verfahren erlaubt eine optimierte Auswahl einer Reihenfolge von k-Raumtrajektorien eines Abtastschemas auch mit hoher Unterabtastungsrate, mit der Artefakte in mittels MRF ermittelten Parameterkarten vermieden oder zumindest reduziert werden können. Mit dem erfindungsgemäßen Verfahren können für ein gewähltes Abtastschema die zu erwartenden Artefakte beschrieben und, z.B. anhand mindestens einer Maßzahl, bewertet werden. Damit können ungünstige Abtastschemata vermieden werden. Das erfindungsgemäße Verfahren erlaubt somit eine einfache und schnelle Auswahl und Bewertung verschiedener gewählter Abtastschemata und eine optimierte Umordnung der jeweiligen Abtastreihenfolgen für MRF-Verfahren. Mit dem erfindungsgemäßen Verfahren kann somit Zeitaufwand für Testmessungen einer schier unendlichen Menge von möglichen Abtastschemata mit unterschiedlichen Unterabtastungsraten und ihrer jeweiligen möglichen Umordnungen in der Reihenfolge der Abtastung der jeweiligen k-Raumtrajektorien vermieden werden.

Mit dem erfindungsgemäßen Verfahren wird eine Abhängigkeit der Artefakte von einem Bildinhalt des abgebildeten Untersuchungsobjekts, beispielsweise der abgebildeten Anatomie, in den Vergleich einbezogen. Das Artefaktverhalten kann also für verschiedene Anwendungen bzw. Anatomien untersucht und optimiert werden. Das erfindungsgemäße Verfahren ist für alle Abtastschemata und beliebige Fingerprintdesigns (zeitliche Kodierung des Signals, Abtastreihenfolgen) anwendbar.

Der Erfindung liegt unter anderem die Erkenntnis zugrunde, dass ein Abtastschema mit einer bestimmten Reihenfolge, in der die umfassten k-Raumtrajektorien gemessen werden und aus denen sich das MRF-Signal ergibt, jeweils spezifische räumliche Einfaltungen generiert. Die Artefakte der Unterabtastung dominieren hierbei andere Signalvariationen wie z.B. durch Systemimperfektionen. Eine zeitliche Umordnung der Reihenfolge der k-Raumtrajektorien entspricht somit einer Umordnung der Unterabtastungsartefakte. Abtastschemata mit einer Abtastreihenfolge, die inkohärente Artefakte erzeugen, sind somit besser für MRF-Verfahren geeignet, da diese beim Matching, wie im genannten Artikel von Jiang erwartet, weniger ins Gewicht fallen. Daher kann die Bestimmung der bevorzugten Reihenfolge insbesondere eine Bestimmung einer Maßzahl umfassen, die eine Inkohärenz von in aus gemäß der entstandenen Reihenfolgen bestimmten unterabgetasteten Messdatensätzen rekonstruierten Bilddaten enthaltenen Artefakten wiedergibt.

Die Bestimmung der bevorzugten Reihenfolge kann zusätzlich oder alternativ eine Simulation von in aus gemäß der entstandenen Reihenfolgen bestimmten unterabgetasteten Messdatensätzen rekonstruierten Bilddaten eines, z.B. digitalen, Untersuchungsobjekts enthaltenen Artefakten umfassen. Eine Simulation ist ohne großen Aufwand für eine unbeschränkte Vielzahl von möglichen Abtastschemata und Abtastreihenfolgen möglich und verlangt allenfalls geringe tatsächliche Messzeiten an einer Magnetresonanzanlage. Die Simulation erlaubt eine direkte Darstellung der zu erwartenden Artefakte in durch MRF-Verfahren erhaltenen Parameterkarten.

Sowohl die genannte Maßzahl als auch die Simulation erlauben eine objektive Beurteilung von mit einen gewünschten Abtastschema und einer Abtastreihenfolge zu erwartenden Artefakten. Bei einem erfindungsgemäßen Verfahren zum Messen von Messdaten eines Untersuchungsobjekts für ein Magnetresonanz-Fingerprinting-Verfahren und bei einem erfindungsgemäßen Verfahren zum Erstellen von Parameterkarten eines Untersuchungsobjekts mittels Magnetresonanz-Fingerprinting werden die Messdaten entlang von k-Raumtrajektorien in einer gemäß einem hierin beschriebenen Verfahren bestimmten bevorzugten Reihenfolge gemessen.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung sowie einer Bestimmungseinheit zum Bestimmen von bevorzugten Reihenfolgen und einer MRF-Einheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren zur Bestimmung einer bevorzugten Reihenfolge entlang welcher in der bevorzugten Reihenfolge nacheinander Messdatensätze für Magnetresonanz-Fingerprinting-Verfahren angegebenen Vorteile und Ausführungen gelten analog auch für das Verfahren zur Messung von Messdaten, das Verfahren zum Erstellen von Parameterkarten sowie für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Fig. 1 ein schematisches Ablaufdiagramm eines erfindungsgemäßen Verfahrens zur Bestimmung einer bevorzugten Reihenfolge von N k-Raumtrajektorien,

Fig. 2 ein schematisches Ablaufdiagramm von erfindungsgemäßen Verfahren zum Messen von Messdaten eines Untersuchungsobjekts für ein Magnetresonanz-Fingerprinting-Verfahren und zum Erstellen von Parameterkarten eines Untersuchungsobjekts mittels Magnetresonanz-Fingerprinting,

Fig. 3 einen Ausschnitt von wiederholt in einer Reihenfolge $Ord_k$ gemessenen Messwerten zur Veranschaulichung eines Verfahrens,

Fig. 4 Beispiele von Differenzsignalen Diff(t) für verschiedene Messungen einer Reihenfolge $Ord_1$,

Fig. 5 Beispiele von Differenzsignalen Diff(t) für verschiedene Messungen einer Reihenfolge $Ord_2$,

Fig. 6 Beispiele von Differenzsignalen Diff(t) für verschiedene Messungen einer Reihenfolge $Ord_3$,

Fig. 7 Beispiele von Differenzsignalen Diff(t) für verschiedene Messungen einer Reihenfolge $Ord_4$,

Fig. 8 einen Vergleich von für jede Reihenfolge der Figuren 4 bis 7 gemittelten Differenzsignalen Diff(t), die gemäß einer festen Abfolge zu gemittelten Differenzsignalen Diff(o) umgeordnet wurden,

Fig. 9 eine beispielhafte Wichtungsfunktion, wie sie in einem erfindungsgemäßen Verfahren zum Gewichten verwendet werden kann,

Fig. 10 Ergebnisse einer Maßzahl MZ1 zu verschiedenen untersuchten Reihenfolgen $Ord_k$,

Fig. 11 eine schematisch dargestellte erfindungsgemäße Magnetresonanzanlage.

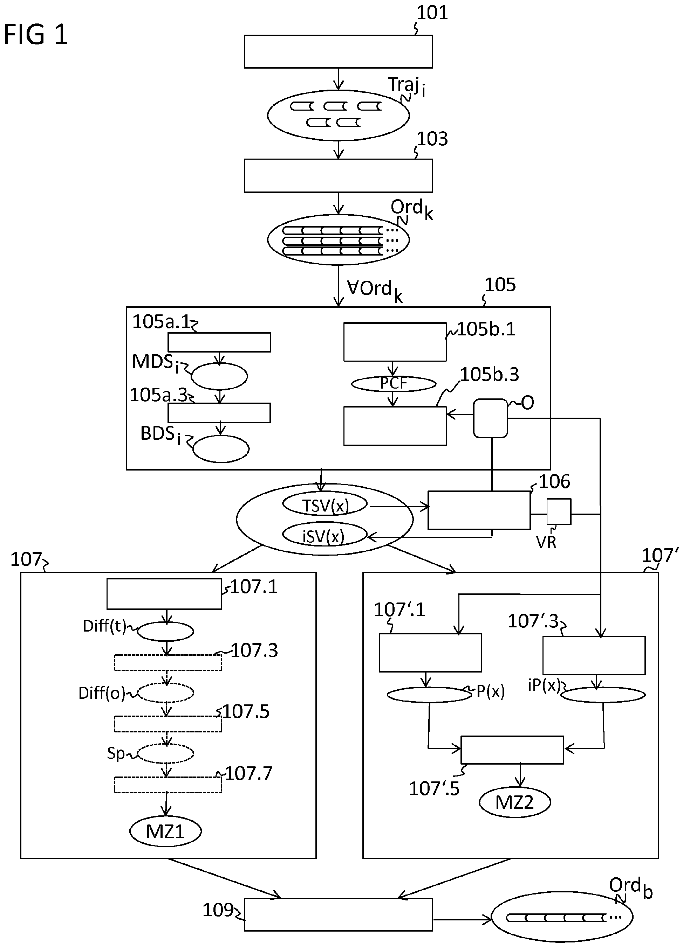

Figur 1 ist ein schematisches Ablaufdiagramm eines erfindungsgemäßen Verfahrens zur Bestimmung einer bevorzugten Reihenfolge von N k-Raumtrajektorien, entlang welcher (in der bevorzugten Reihenfolge nacheinander)

jeweils ein unterabgetasteter Messdatensatz für eine Magnetresonanz-Fingerprinting-Messung gemessen werden soll.

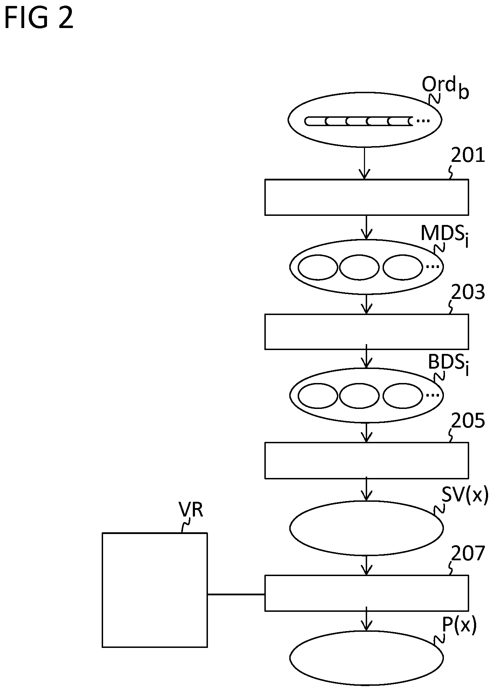

Ein Abtastschema wird gewählt (Block 101), welches N (N > 1) k-Raumtrajektorien Traj$_i$ (i = 1, ..., N) umfasst, entlang derer Messdaten derart aufgenommen werden können, dass aus den entlang jeweils einer der N k-Raumtrajektorien Traj$_i$ gemessenen Messdaten ein gemäß Nyquist unterabgetasteter Messdatensatz erstellt werden kann. Aus mindestens zwei jeweils aus einem der unterabgetasteten Messdatensätze rekonstruierten Bilddatensätzen kann ein Signalverlauf mindestens eines Bildpunktes der Bilddatensätze ermittelt werden. Aus den ermittelten Signalverläufen kann durch Vergleichen der bestimmten Signalverläufe mit einer Vergleichsregel ein Parameter des Untersuchungsobjekts pro rekonstruiertem Bildpunkt bestimmt werden, wie es beispielsweise weiter unten mit Bezug auf Figur 2 beschrieben ist.

Die k-Raumtrajektorien können hierbei spiralförmig, radial oder kartesisch sein. Die k-Raumtrajektorien Traji können insbesondere derart gewählt werden, dass entlang aller N k-Raumtrajektorien Traj$_i$ gemessene Messdaten zusammen einen gemäß Nyquist vollständig abgetasteten Messdatensatz ergeben. Die Reihenfolge, in welcher die N k-Raumtrajektorien Traj$_i$ zeitlich nacheinander abgetastet werden sollen, wird variiert (Block 103), sodass zumindest zwei unterschiedliche Reihenfolgen Ord$_k$ (k>1) entstehen. Dabei kann grundsätzlich eine zufällige Variation vorgenommen werden. Es kann aber auch eine periodische Variation vorgenommen werden, beispielsweise eine Drehung um einen gewissen Winkelschritt, beispielsweise ein natürliches Vielfaches des Winkels 360°/N, oder einen Versatz in einer Raumrichtung, insbesondere einen Versatz um jeweils einen periodisch im k-Raum fortgesetzten Schritt. Bei gleicher periodischer Drehung bzw. bei gleichem periodischem Versatz kann eine weitere Variation durch Variieren der Start-k-Raumtrajektorie ("Offset") erreicht werden. Entsprechend der durch die Variation entstandenen Reihenfolgen Ord$_k$ werden Test-Signalverläufe TSV(X) ermittelt (Block 105), um sie mit idealen Signalverläufen und optional miteinander vergleichen zu können (Blöcke 107, 107').

Die Test-Signalverläufe für das Vergleichen der Reihenfolgen (Ord$_k$) können für mindestens einem Bildpunkt von aus in Testmessungen (Block 105a.1) entlang der N k-Raumtrajektorien Traj$_i$ in den jeweils entstandenen Reihenfolgen gemessenen unterabgetasteten Messdatensätzen MDS$_i$ rekonstruierten Bilddatensätzen BDS$_i$ (Block 105a.3) bestimmt werden. Ein Bilddatensatz umfasst hierbei mindestens einen Bildpunkt x. Ein Vergleichen der Reihenfolgen Ord$_k$ kann somit Testmessungen 105a.1 zur Bestimmung von ersten Test-Signalverläufen umfassen. Derartige Testmessungen können an verschiedenen Untersuchungsobjekten durchgeführt werden, sodass für verschiedene Untersuchungsobjekte, z.B. bezüglich verschiedener medizinischer Fragestellungen, jeweils eine bevorzugte Reihenfolge Ord$_b$ bestimmt werden kann.

Je mehr der N k-Raumtrajektorien Traj$_i$ zur Bestimmung der Test-Signalverläufe herangezogen werden, indem aus den zugehörigen Messdatensätzen Bilddatensätze rekonstruiert werden, von denen mindestens ein Bildpunkt betrachtet wird, und je mehr Bildpunkte pro rekonstruierten Bilddatensätzen betrachtet werden, desto aussagekräftiger fällt der Vergleich aus. Hierbei können die N k-Raumtrajektorien auch mehrmals in der untersuchten Reihenfolge Ord$_k$ gemessen werden, um mehrere Signalverläufe des mindestens einen Bildpunktes x für eine bestimmte Reihenfolge Ord$_k$ zu erhalten. Dadurch kann die Aussagekraft des Vergleichs, beispielsweise durch Bilden von Mittelwerten, weiter erhöht werden.

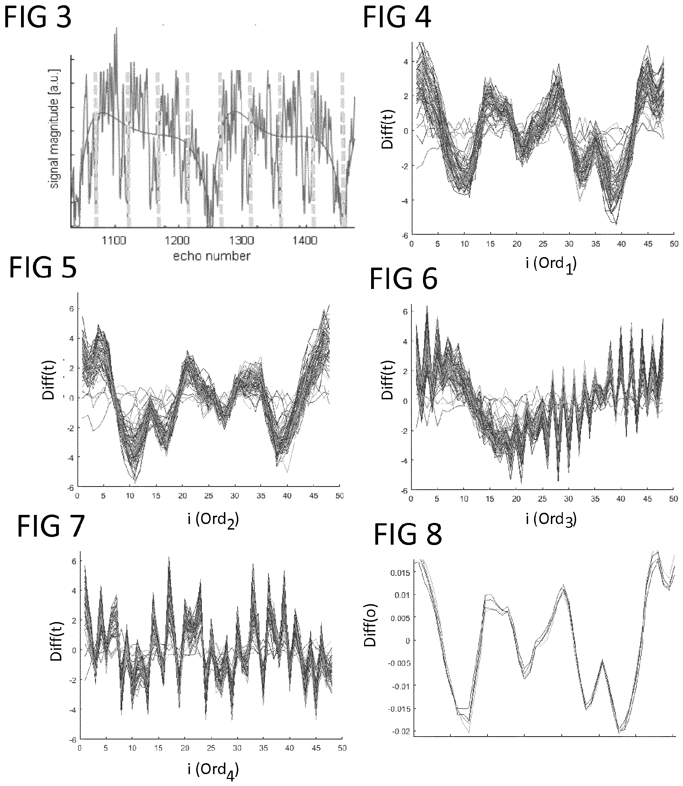

Ein Beispiel für derartige Testmessungen ist in Figur 3 gegeben, die einen Ausschnitt von in einem Messvorgang nacheinander mit einer festen Reihenfolge Ord$_k$ gemessenen Signal-Magnituden über den gemäß der Reihenfolge Ord$_k$ durch Abtasten der k-Raumtrajektorien erzeugten Echos zeigt (stark schwankender, "zappelnder" Graph). Die Anzahl der gemessenen Echos übersteigt in diesem Beispiel um ein Vielfaches die Zahl N der k-Raumtrajektorien, sodass mehrere Signalverläufe pro Bildpunkt und Reihenfolge Ord$_k$ gewonnen werden. Die gemessenen Zyklen, d.h. die jeweiligen Durchläufe der untersuchten Reihenfolge Ord$_k$, sind in Figur 3 durch gestrichelte senkrechte Linien voneinander getrennt.

Es können aber auch zusätzlich oder alternativ Test-Signalverläufe für das Vergleichen der Reihenfolgen (Ord$_k$) mittels Simulation bestimmt werden. Dazu kann für jede der N k-Raumtrajektorien Traj$_i$ eine Bestimmung eines (fremden) Anteils eines Signals mindestens eines Bildpunktes umfassen, welcher Bildpunkt jeweils aus einem entlang einer der k-Raumtrajektorien gemessenen Messdatensatz rekonstruiert wurde, welcher fremde Anteil tatsächlich anderen Bildpunkten zuzuordnen wäre (Block 105b.1). Dieser Anteil entspricht somit dem Anteil des Signals eines Bildpunktes, der aus allen anderen Bildpunkten eingefaltet wird. Dies kann durch Berechnen der als "Point Collection Function" (PCF) bezeichneten Funktion erreicht werden. Die PCF geht erfindungsgemäß aus der bekannten "Point Spread Function" (PSF) folgendermaßen hervor:

$$PCF(x_1, x_2) = \int \delta(x' - x_2) PSF(x', x_1) dV' = PSF(x_2, x_1)$$

PCF $(x_1, x_2)$ beschreibt somit den Anteil an Signal, der von dem Bildpunkt $x_1$ fälschlich dem Bildpunkt $x_2$ zugeordnet wurde. Das entspricht der PSF $(x2, x1)$, die beschreibt, wie viel Signal des Bildpunktes $x_2$ eigentlich dem

Bildpunkt $x_1$ zugeordnet werden müsste. Es kann somit für jede der N k-Raumtrajektorien $Traj_i$ die zugehörige PCF für mindestens einen Bildpunkt x als der genannte fremde Anteil bestimmt werden.

Mit Hilfe der bestimmten, z.B. durch die PCF beschriebenen, fremden Signalanteile eines Bildpunktes können Test-Signalverläufe TSV(X) bestimmt werden (Block 105b.3). Ein Test-Signalverlauf TSV(X)' eines Bildpunktes $x_1$ kann mit Hilfe der PCF bestimmt werden, indem für alle Zeitpunkte $t_N$ das Signal $I(x_1)$ berechnet wird gemäß:

$$I(x_1) = \int PCF(x_1, x_2)O(x_2)dx_2,$$

wobei $O(x_2)$ eine Intensität von jeweiligen Punktquellen für jeden Bildpunkt $x_2$ angibt und eine Beschreibung O eines Untersuchungsobjekts als Verteilung von Punktquellen ist. Jedem Zeitpunkt $t_N$ der Signalverläufe ist eine der N k-Raumtrajektorien zugeordnet, deren Reihenfolge durch die Reihenfolge $Ord_k$ vorgegeben wird. Als eine derartige Beschreibung O eines Untersuchungsobjekts können z.B. digitale Phantome verwendet werden, die auch auf Basis von realen Messbedingungen (z.B. Spulensensitivitäten, Inhomogenitäten in Magnet- und Hochfrequenzfeldern von zu verwendenden Magnetresonanzanlagen) und realen Untersuchungsobjekten individuell angepasst werden können. Es können Beschreibungen O für verschiedenartige Untersuchungsobjekte, z.B. homogene, mehrere unterschiedliche aneinandergrenzende Gewebe beschreibende, oder verschiedene Anatomien abbildende, eingesetzt werden, um für die jeweils beschriebenen verschiedenen Untersuchungsobjekte jeweils individuell bevorzugte Reihenfolgen $Ord_b$ zu bestimmen.

Weiterhin können zu den bestimmten Test-Signalverläufen TSV(x) korrespondierende erste ideale Signalverläufe iSV(x) der entsprechenden Bildpunkte x bestimmt werden (Block 106). Dabei kann beispielsweise als ein idealer Signalverlauf iSV(x) ein mit einem MRF-Verfahren anhand einer geeigneten Vergleichsregel VR und eines zugehörigen Dictionarys bestimmter bester Vergleichs-Signalverlauf des Dictionarys bestimmt werden, der z.B. am besten mit den Test-Signalverläufen korrespondiert. Ein Beispiel eines derartigen idealen Signalverlaufs ist in Figur 3 durch den zweiten, sich jeweils in etwa in einem mittleren Bereich der gemessenen Signal-Magnituden befindlichen, Graphen dargestellt.

Wenn zumindest ein Parameterwert bekannt ist, können die idealen Signalverläufe iSV(x) aus denjenigen Vergleichs-Signalverläufe eines Dictionarys einer passenden MRF-Vergleichsregel VR bestimmt werden, die den, z.B. für ein von der Beschreibung O beschriebene Untersuchungsobjekt bekannten, Parametern des Untersuchungsobjektes am besten entsprechen, z.B. kann derjenige Vergleichs-Signalverlauf als idealer Signalverlauf iSV(x) bestimmt werden, der einem dem bekannten Parameterwert am besten entsprechenden Parameterwert zugeordnet ist.

Ein Vergleich 107 der Test-Signalverläufe TSV(x) mit idealen Signalverläufen iSV(x) kann ein Bilden eines Differenzsignals Diff(t) der bestimmten ersten Test-Signalverläufe TSV(x) mit ihren korrespondierenden bestimmten ersten idealen Signalverläufen iSV(x) umfassen (Block 107.1). Die gebildeten Differenzsignale können bei der Bestimmung der bevorzugten Reihenfolge berücksichtigt werden. Wurden die N k-Raumtrajektorien $Traj_i$ mehrmals in einer untersuchten Reihenfolge $Ord_k$ gemessen, um mehrere Signalverläufe SV(x) des mindestens einen Bildpunktes x für eine bestimmte Reihenfolge $Ord_k$ zu erhalten, können die jeweils für eine bestimmte Reihenfolge $Ord_k$ gebildeten Differenzsignale Diff(t) beispielsweise gemittelt werden und das gemittelte Differenzsignal Diff(t), und somit wieder nur ein Differenzsignal Diff(t) pro Reihenfolge $Ord_k$ betrachtet werden.

In den Figuren 4 bis 7 sind beispielhaft jeweils mehrere Differenzsignale Diff(t) in willkürlichen Einheiten über die durch die jeweilige Reihenfolge $Ord_1$, $Ord_2$, $Ord_3$ bzw. $Ord_4$ Abfolge i der k-Raumtrajektorien $Traj_i$ gezeigt. Die in jeder der Figuren 4 bis 7 übereinander geplotteten mehreren Differenzsignale Diff(t) können hierbei beispielsweise aus einem wie in Figur 3 gezeigten Signal-Magnituden-Verlauf bestimmt werden, wobei für jeden Zyklus der jeweiligen Reihenfolge ein Differenzsignal Diff(t) durch Bilden der jeweiligen Differenzen zu dem jeweiligen idealen Signal gewonnen werden kann, und diese Differenzsignale Diff(t) jeweils gemäß der durch die jeweilige Reihenfolge $Ord_1$, $Ord_2$, $Ord_3$ bzw. $Ord_4$ Abfolge i der k-Raumtrajektorien $Traj_i$ aufgetragen werden. Aus den zu einer Reihenfolge $Ord_k$ ermittelten mehreren Differenzsignalen Diff(t) eines Bildpunktes, wie sie z.B. jeweils in den Figuren 4 bis 7 dargestellt sind, kann für jede betrachtete Reihenfolge und jeden betrachteten Bildpunkt auch ein gemeinsamer Wert, z.B. ein Mittelwert, bestimmt werden, sodass pro Reihenfolge und Bildpunkt nur ein (z.B. das gemittelte) Differenzsignal Diff(t) betrachtet werden kann.

Für eine bessere Vergleichbarkeit der verschiedenen Reihenfolgen $Ord_k$ kann weiterhin die untersuchten Differenzsignale Diff(t) gemäß einer festen Abfolge zu jeweils einem Differenzsignal Diff(o) umgeordnet werden (Block 107.3). Dabei kann die feste Abfolge beispielsweise die N k-Raumtrajektorien $Traj_i$ derart anordnen, dass eben nicht deren für jede Reihenfolge $Ord_k$ andersartige zeitliche Abfolge, sondern beispielsweise deren räumliche Anordnung die feste Abfolge vorgibt. Bei radialen oder spiralen N k-Raumtrajektorien, die beispielsweise jeweils um einen Winkel 360°/N gegeneinander verdreht sind, kann die feste Abfolge durch den Winkel vorgegeben sein (z.B. 0°, 360°/N, 2*360°/N, ...) oder z.B. für kartesische k-Raumtrajektorien durch Schritte von einem "k-Raum-Rand" zum anderen. In jedem Fall werden die Differenzsignale Diff(t) derart umgeordnet, dass nunmehr Differenzwerte, die einer der N k-Raumtrajektorie zugeordnet werden können, in jedem umgeordneten Differenzsignal Diff(o) für alle untersuchten Reihenfolgen $Ord_k$ an

einer gleichen Position liegen. Auf diese Weise werden die durch die verschiedenen Reihenfolgen $Ord_k$ erhaltenen Differenzsignale besser vergleichbar.

Ein Beispiel eines solchen Vergleichs ist in Figur 8 gezeigt, in der beispielhaft die für jede Reihenfolge $Ord_1$, $Ord_2$, $Ord_3$ bzw. $Ord_4$ der Figuren 4 bis 7 gemittelten Differenzsignalen Diff(t), die gemäß einer festen Abfolge zu umgeordneten Differenzsignalen Diff(o) umgeordnet wurden, aufgetragen sind. Jeder der dargestellten Graphen zeigt das (im dem gezeigten Beispiel gemittelte) umgeordnete Differenzsignal Diff(o) einer der Reihenfolgen $Ord_1$, $Ord_2$, $Ord_3$ bzw. $Ord_4$.

Weiterhin kann für jede Reihenfolge $Ord_k$ je eine Frequenzanalyse der in einer festen Abfolge betrachteten gebildeten Differenzsignale Diff(o) durchgeführt werden (Block 107.5), um die Spektren Sp der Differenzsignale Diff(o) der verschiedenen Reihenfolgen $Ord_k$ vergleichen zu können. Die Frequenzanalyse kann beispielsweise durch eine Fourier-Analyse der Differenzsignale Diff(o) erstellt werden. Ein Betrachten der Spektren der umgeordneten Differenz-signale Diff(o) erlaubt eine Bestimmung einer Inkohärenz von in aus gemäß der entstandenen Reihenfolgen $Ord_k$ be-stimmten unterabgetasteten Messdatensätzen rekonstruierten Bilddaten enthaltenen Artefakten. Niedrige Frequenzen in den ermittelten Spektren Sp lassen auf eine nur langsame Änderung der Fehler durch Unterabtastungsartefakte schließen. Hohe Frequenzen in den ermittelten Spektren Sp weisen hingegen auf eine gewünschte schnelle Änderung, d.h. hohe Variabilität, der Artefakte hin. Bevorzugt sind daher Reihenfolgen $Ord_k$ von Abtastschemata, die in einem derartigen Spektrum Sp höhere Frequenzen enthalten.

Die Ergebnisse der Frequenzanalyse, d.h. die erhaltenen Spektren Sp, können weiterhin derart, z.B. mit einer Wichtungsfunktion, gewichtet werden, dass kleine Frequenzen höher gewichtet werden als hohe Frequenzen (Block 107.7). Durch eine derartige Gewichtung der Spektren lassen sich diejenigen Spektren mit den gewünschten Eigenschaften (höhere Frequenzen) leichter von Spektren mit den nicht gewünschten Eigenschaften (niedrigere Frequenzen) unterscheiden, da die ungewünschten niedrigen Frequenzen auffälliger werden.

Beispielsweis durch eine Summation eines derartigen gewichteten Spektrums pro Reihenfolge über die Frequenzen des Spektrums und ggf. auch eine Summation über alle bezüglich dieser Reihenfolge betrachteten Bildpunkte x kann eine Maßzahl MZ1 pro Reihenfolge $Ord_k$ bestimmt werden, mit der die Auswirkungen der Unterabtastungsartefakte dieser Reihenfolge $Ord_k$ in MRF-Verfahren objektiv abgeschätzt werden können. Durch die Gewichtung werden die unerwünschten niedrigen Frequenzen in den Spektren hoch gewichtet und die gewünschten hohen Frequenzen in den Spektren niedrig gewichtet. Somit sind Reihenfolgen mit niedrigen derartigen Maßzahlen MZ1 gegenüber Reihenfolgen mit höheren derartigen Maßzahlen MZ1 bevorzugt.

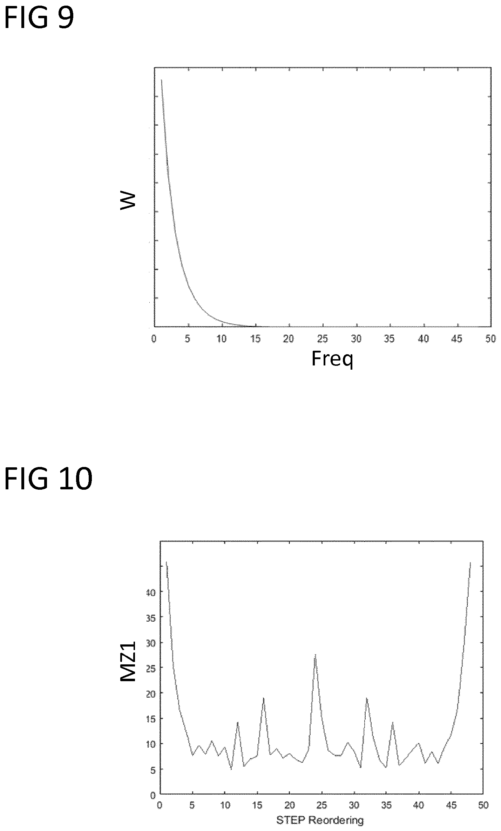

Ein Beispiel für eine für das Gewichten der Spektren geeignete Wichtungsfunktion W ist in Figur 9 gezeigt. Die gezeigte Wichtungsfunktion W gewichtet die hier in willkürlichen Einheiten aufgetragenen niedrigen Frequenzen (Freq) hoch und fällt exponentiell ab, sodass hohe Frequenzen nur schwach gewichtet werden.

Figur 10 zeigt beispielhafte Ergebnisse einer Maßzahl MZ1 zu verschiedenen untersuchten Reihenfolgen Ordk, die hier als "STEP Reordering" bezeichnet sind, da die gezeigten Reihenfolgen durch eine Variation einer Startreihenfolge durch Schritte mit den in der Abszisse aufgetragenen Schrittweiten erhalten wurden, d.h. die Schrittweite "1" entspricht der Startreihenfolge ($Traj_1$, $Traj_2$, ..., $Traj_N$), die Schrittweite "2" entspricht einer Reihenfolge ($Traj_1$, $Traj_3$, $Traj_5$, ..., $Traj_{N-1}$, $Traj_2$, $Traj_4$, $Traj_6$, ..., $Traj_N$) usw., d.h. die hier gewählten Reihenfolgen geben ausgehend von der ersten k-Raumtrajektorie Traji jeweils als nächstes die der Schrittweite entsprechende nächste k-Raumtrajektorie vor, wobei, um insgesamt alle N k-Raumtrajektorien abzudecken, die jeweils nächste k-Raumtrajektorie als nächstes in der Reihenfolge angegeben wird, die bisher noch nicht in der Reihenfolge enthalten ist, wenn die gemäß der Schrittweite nächste k-Raumtrajektorie bereits in der Reihenfolge enthalten ist.

In dem gezeigten Beispiel hat die Reihenfolge mit der Schrittweite 11 die niedrigste Maßzahl MZ1 und ist daher am besten geeignet, um durch Unterabtastungsartefakte verursachte Fehler in mittels MRF-Verfahren ermittelten Parameterkarten zu vermeiden.

Ein weiterer, zusätzlicher oder alternativer Vergleich 107' von Test-Signalverläufen TSV(x) mit idealen Signalverläufen iSV(x) kann ein Vergleichen der Test-Signalverläufe TSV(x) mit einer Vergleichsregel VR umfassen (Block 107'.1), wobei die Vergleichsregel gemäß einer Übereinstimmung der Test-Signalverläufe TSV(x) mit Vergleichs-Signalverläufen eines Dictionarys, denen mindestens ein Parameter zugeordnet ist, für jeden zugeordneten Parameter denjenigen Parameterwert auswählt, der dem Vergleichs-Signalverlauf mit der größten Übereinstimmung mit dem Test-Signalverlauf TSV(x) entspricht, und diesen Parameterwert P(x) dem Bildpunkt x des Test-Signalverlaufs TSV(x) zuordnet.

Dieser Parameterwert P(x) kann mit einem für den entsprechenden Bildpunkt in Bilddaten des Untersuchungsobjekts erwarteten Parameterwert iP(x) verglichen werden, wenn dieser bekannt oder bestimmbar ist (Block 107'.5). Der erwartete Parameterwert iP(x) kann hierbei, zumindest für Test-Signalverläufe TSV(x), die simulierte Test-Signalverläufe sind, beispielsweise anhand des der Beschreibung O zugrundeliegenden Untersuchungsobjekts bestimmt werden (Block 107'.3).

Bei dem Vergleich 107'.5 können zusätzlich oder alternativ zu einem Vergleichen von Parameterwerten P(x) verschiedener Reihenfolgen $Ord_k$ mit erwarteten Parameterwerten iP(x) auch Vergleiche von Parameterwerten P(x) verschiedener Reihenfolgen untereinander, z.B. auch für verschiedene Bildpunkte x, gemacht werden. Dies kann insbesondere dann sinnvoll sein, wenn z.B. eine räumliche Verteilung der Parameterwerte P(x) vorausgesetzt werden kann, insbesondere wenn eine räumlich homogene Verteilung erwartet wird. Denn dann kann ein Vergleichen von Parameterwerten P(x) für verschiedene Bildpunkte x bezüglich einer Reihenfolge $Ord_k$ Aufschluss geben, über die Korrektheit der mit den Parameterwerten P(x) erhaltenen räumlichen Verteilung der Parameterwerte. Beispielsweise sollten die ermittelten Parameterwerte P(x)keinen großen Schwankungen unterworfen sein, wenn ein homogenes Untersuchungsobjekt untersucht wurde. Die Güte der für die jeweiligen Reihenfolgen $Ord_k$ ermittelten Parameterwerte P(x) kann z.B. mittels einer zweiten Maßzahl MZ2 leichter vergleichbar gemacht werden. Eine solche Maßzahl kann z.B. eine statistische Abweichung der ermittelten Parameterwerte P(x) von den erwarteten Parameterwerten iP(x) widerspiegeln und/oder ein Maß einer Homogenität der ermittelten Parameterwerte P(x) über verschiedene Bildpunkte x berücksichtigen. Durch die ermittelten Parameterwerte P(x) können die Auswirkungen der Unterabtastung der zugrundeliegenden k-Raumtrajektorien auf mittels MRF-Verfahren erstellte Parameterkarten dargestellt werden.

Aus den durch die Variation entstandenen Reihenfolgen $Ord_k$ wird unter Berücksichtigung der Ergebnisse der angestellten Vergleiche 107, 107' von Test-Signalverläufen TSV(x) mit idealen Signalverläufen iSV(x) und optional untereinander eine bevorzugte Reihenfolge $Ord_b$ bestimmt (Block 109) .

Die Ergebnisse der Vergleiche können insbesondere ermittelte Differenzsignale Diff(t), umgeordnete Differenzsignale Diff(o), Spektren Sp von Frequenzanalysen von Differenzsignalen, oder aus den Vergleichen gewonnene Maßzahlen MZ1 oder MZ2 sein.

Dabei kann die Bestimmung der bevorzugten Reihenfolge $Ord_b$ verschiedene Vergleiche von Test-Signalverläufen TSV(x) mit idealen Signalverläufen iSV(x) pro erhaltener Reihenfolge $Ord_k$ und/oder Vergleiche von verschiedenen Test-Signalverläufen TSV(x) einer Reihenfolge $Ord_k$ untereinander einzeln oder auch kombiniert berücksichtigen.

Figur 2 ist ein schematisches Ablaufdiagramm eines Verfahrens zum Messen von Messdaten eines Untersuchungsobjekts für ein Magnetresonanz-Fingerprinting-Verfahren und weiterhin eines Verfahrens zum Erstellen von Parameterkarten eines Untersuchungsobjekts mittels Magnetresonanz-Fingerprinting.

Für eine MRF-Messung an einem Untersuchungsobjekt wird eine gemäß einem in Bezug auf Figur 1 beschriebenen Verfahren bestimmte bevorzugte Reihenfolge $Ord_b$ eines gewählten Abtastschemas geladen.

Entlang von in der bevorzugten Reihenfolge $Ord_b$ angeordneten k-Raumtrajektorien eines gewählten Abtastschemas werden Messdaten eines Untersuchungsobjekts mittels einer Magnetresonanzanlage gemessen (Block 201). Aus den gemessenen Messdaten wird z.B. pro k-Raumtrajektorie je ein unterabgetasteter Messdatensatz $MDS_i$ erstellt. Die Messdatensätze $MDS_i$ liegen somit in einer zeitlichen Reihenfolge vor, die der bevorzugten Reihenfolge entspricht. Es ist auch möglich, mehrere pro k-Raumtrajektorie gemessene Messdaten zu einem unterabgetasteten Messdatensatz $MDS_i$ zusammenzufassen, wodurch ein solcher Messdatensatz $MDS_i$ weniger stark unterabgetastet ist und damit weniger mit Unterabtastungsartefakten behaftet sein sollte. Derartige zusammengefasste Messdatensätze $MDS_i$ haben jedoch eine geringere zeitliche Auflösung.

Aus den Messdatensätzen $MDS_i$ werden jeweils Bilddatensatze $BDS_i$ rekonstruiert (Block 203), die ebenfalls in einer zeitlichen Reihenfolge vorliegen, die der bevorzugten Reihenfolge entspricht. Ein Bilddatensatz $BDS_i$ umfasst hierbei mindestens einen Bildpunkt x.

Für mindestens einen Bildpunkt x der rekonstruierten Bilddatensätze $BDS_i$ wird ein Signalverlauf SV(x) bestimmt, der die Signalintensität des Bildpunktes in einer der bevorzugten Reihenfolge entsprechenden zeitlichen Abfolge wiedergibt (Block 205).

Es wird mindestens ein Parameter P(x) für mindestens einen Bildpunkt x, für den ein Signalverlauf bestimmt wurde, bestimmt durch Vergleichen der bestimmten Signalverläufe SV(x) mit einer Vergleichsregel VR, die gemäß einer Übereinstimmung der Signalverläufe SV(x) mit in der Vergleichsregel VR hinterlegten Vergleichs-Signalverläufen, denen mindestens ein Parameter zugeordnet ist, denjenigen Parameterwert auswählt, der dem Vergleichs-Signalverlauf mit der größten Übereinstimmung mit dem bestimmten Signalverlauf entspricht und diesem dem jeweiligen Bildpunkt zuordnet (Block 207).

Als Vergleichsregel kann eine bei MRF-Verfahren übliche Vergleichsregel verwendet werden, die insbesondere ein sogenanntes Pattern-Matching umfassen kann. Somit wird eine Parameterkarte mit Parameterwerten P(x) pro Bildpunkt x eines Untersuchungsobjekts mit Hilfe eines MRF-Verfahrens erstellt.

Es wird somit eine Bestimmung einer bevorzugten Reihenfolge von N k-Raumtrajektorien, entlang welcher jeweils ein unterabgetasteter Messdatensatz für eine MRF-Messung gemessen werden soll, ermöglicht, derart, dass Artefakte in aus den Messdatensätzen mittels MRF-Verfahren erstellten Parameterkarten vermieden werden.

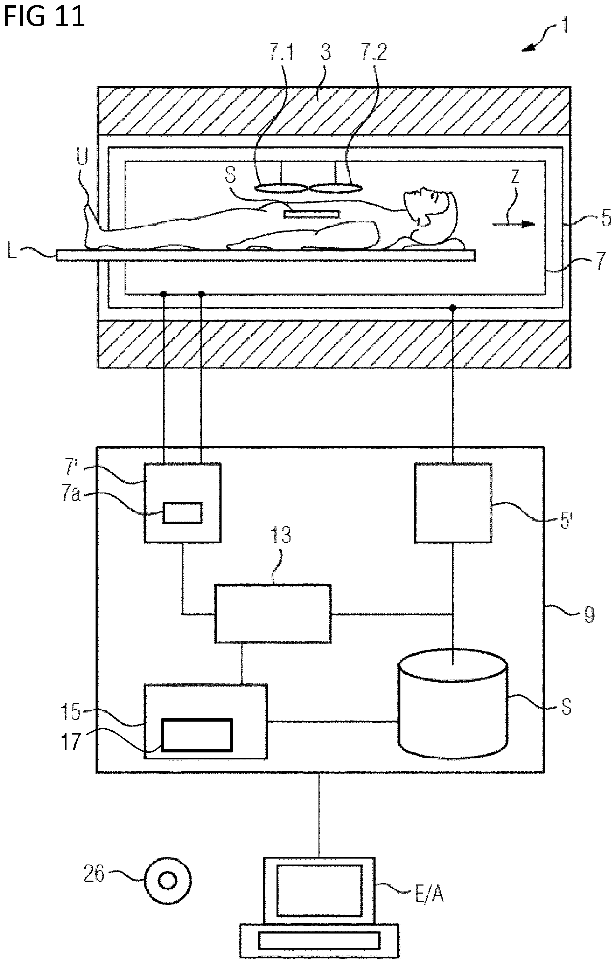

Figur 11 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 11 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonananzanlage 1 in deren Messvolumen eingebracht werden. Die Schicht S stellt ein exemplarisches Zielvolumen des Untersuchungsobjekts dar, aus dem Messdaten aufgenommen werden können.

Die Steuereinrichtung 9 dient der Steuerung der Magnetresonananzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei liegt die Mittenfrequenz des, auch als B1-Feld bezeichneten, Hochfrequenz-Wechselfeldes üblicherweise nahe der Resonanzfrequenz der zu manipulierenden Spins. Zur Erzeugung des B1-Feldes werden in der Hochfrequenzeinheit 7 mittels der Hochfrequenz-sende/empfangs-Steuerung 7' gesteuerte Ströme an den HF-Spulen angelegt. Eine erfindungsgemäße Messdatenaufteilungseinheit 7a, die beispielsweise von der Hochfrequenz-Sende-/Empfangs-Steuerung 7' umfasst sein kann, bestimmt welche Messdaten erfindungsgemäß aufgenommen und welchem Datensatz zugeordnet werden.

Weiterhin umfasst die Steuereinrichtung 9 eine Bestimmungseinheit 15, die z.B. Strategien bereitstellt mit welchen eine erfindungsgemäße bevorzugte Reihenfolge bestimmt werden kann, in welcher k-Raum-Trajektorien eines Abtastschemas erfindungsgemäß optimiert nacheinander abgetastet werden sollen. Mit der Bestimmungseinheit 15 kann eine MRF-Einheit 17 verbunden sein, die zur Durchführung von MRF-Verfahren ausgelegt ist, und insbesondere Zugriff auf Vergleichsregeln und Vergleichs-Signalverläufe hat. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonananzanlage 1 können, z.B. durch einen Nutzer, Steuerbefehle an die Magnetresonananzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonananzanlage 1 das beschriebene Verfahren durchführen.

**Patentansprüche**

1. Computerimplementiertes Verfahren zur Bestimmung einer bevorzugten Reihenfolge von N k-Raumtrajektorien (Traj$_i$), entlang welcher jeweils ein unterabgetasteter Messdatensatz (MDS$_i$) für eine Magnetresonanz-Fingerprinting(MRF)-Messung gemessen werden kann, umfassend die Schritte:

- Wählen eines Abtastschemas, welches N k-Raumtrajektorien (Traj$_i$) umfasst, entlang derer Messdaten derart aufgenommen werden können, dass aus den entlang mindestens einer der N k-Raumtrajektorien (Traj$_i$) gemessenen Messdaten ein gemäß Nyquist unterabgetasteter Messdatensatz (MDS$_i$) erstellt werden kann, wobei aus den unterabgetasteten Messdatensätzen (MDS$_i$) rekonstruierten Bildpunkten (x) ein Signalverlauf (SV(x)) mindestens eines aus dem unterabgetasteten Messdatensatz (MDS$_i$) rekonstruierten Bildpunktes (x) ermittelt werden kann, und aus den ermittelten Signalverläufen (SV(x)) durch Vergleichen der ermittelten Signalverläufe (SV(x)) mit einer Vergleichsregel (VR) ein Parameter des Untersuchungsobjekts (U) pro rekonstruiertem Bildpunkt (x) bestimmt werden kann,
- Variieren einer Reihenfolge (Ord$_k$) in welcher die N k-Raumtrajektorien (Traj$_i$) zeitlich nacheinander abgetastet werden sollen, sodass zumindest zwei unterschiedliche Reihenfolgen (Ord$_k$) entstehen,

- Vergleichen von entsprechend der durch die Variation entstandenen Reihenfolgen (Ord$_k$) ermittelten Test-Signalverläufen (TSV(x)) mit idealen Signalverläufen (iSV(x)), wobei die idealen Signalverläufe (iSV(x)) aus Vergleichs-Signalverläufen eines Dictionarys eines MRF -Verfahrens bestimmt werden,

- Bestimmen einer bevorzugten Reihenfolge (Ord$_b$) aus den entstandenen Reihenfolgen (Ord$_k$), mit der Artefakte in mittels MRF ermittelten Parameterkarten vermieden oder zumindest reduziert werden können, unter Berücksichtigung der Ergebnisse des Vergleichens.

2. Verfahren nach Anspruch 1, wobei Test-Signalverläufe (TSV(x)) für das Vergleichen der Reihenfolgen (Ord$_k$) in mindestens einem Bildpunkt (x) von aus in Testmessungen entlang der N k-Raumtrajektorien (Traj$_i$) in den jeweils entstandenen Reihenfolgen (Ord$_k$) gemessenen unterabgetasteten Messdatensätzen rekonstruierten Bilddatensätzen (BDS$_i$) bestimmt werden.

3. Verfahren nach einem der vorhergehenden Ansprüche, wobei Test-Signalverläufe (TSV(x)) für das Vergleichen der Reihenfolgen (Ord$_k$) mittels Simulation bestimmt werden.

4. Verfahren nach einem der vorhergehenden Ansprüche, wobei die idealen Signalverläufe (iSV(x)) aus Vergleichs-Signalverläufen des Dictionarys mittels einer Vergleichsregel (VR) eines MRF-Verfahrens durch Vergleichen mit den Test-Signalverläufen (TSV(x)) und/oder bei bekannten oder bestimmbaren gesuchten Parameterwerten, durch Wählen des am besten zu den gesuchten Parameterwerten passenden Vergleichs-Signalverlaufs bestimmt werden.

5. Verfahren nach einem der vorhergehenden Ansprüche, wobei das Vergleichen der Reihenfolgen (Ord$_k$) die folgenden Schritte umfasst:

- Bestimmen mindestens eines Test-Signalverlaufs (TSV(x)) mindestens eines Bildpunktes (x),
- Bestimmen von zu den bestimmten Test-Signalverläufen (TSV(x)) korrespondierenden idealen Signalverläufen (iSV(x)) der entsprechenden Bildpunkte (x),
- Bilden eines Differenzsignals (Diff(t)) der bestimmten Test-Signalverläufe (TSV(x)) mit ihren korrespondierenden bestimmten idealen Signalverläufen (iSV(x)),
- Bestimmen der bevorzugten Reihenfolge (Ord$_b$) auf Grundlage der gebildeten Differenzsignale.

6. Verfahren nach Anspruch 5, wobei das Vergleichen der Reihenfolgen (Ord$_k$) je eine Frequenzanalyse der für jede entstandene Reihenfolge (Ord$_k$) in einer festen Abfolge betrachteten gebildeten Differenzsignale (Diff(o)) umfasst, und die bevorzugte Reihenfolge (Ord$_b$) auf Grundlage der Ergebnisse der Frequenzanalysen bestimmt wird.

7. Verfahren nach Anspruch 6, wobei das Vergleichen der Reihenfolgen (Ord$_k$) ein Gewichten der Ergebnisse der Frequenzanalyse, derart, dass kleine Frequenzen höher gewichtet werden als hohe Frequenzen, umfasst, und eine bevorzugte Reihenfolge (Ord$_b$) einen möglichst kleinen Wert für eine Summe über die gewichteten Ergebnisse der Frequenzanalysen aufweist.

8. Verfahren nach Anspruch 3, wobei die Simulation für jede der N k-Raumtrajektorien (Traj$_i$) eine Bestimmung eines Anteils eines Signals mindestens eines Bildpunktes (x) umfasst, welcher jeweils aus einem entlang einer der k-Raumtrajektorien (Traj$_i$) gemessenen Messdatensatz (MDS$_i$) rekonstruiert wurde, der tatsächlich anderen Bildpunkten (x) zuzuordnen wäre.

9. Verfahren nach einem der vorhergehenden Ansprüche, wobei das Vergleichen der Reihenfolgen (Ord$_k$) die Schritte umfasst:

- Bestimmen von Test-Signalverläufen (TSV(x)) für mindestens einen Bildpunkt (x),
- Vergleichen der Test-Signalverläufe (TSV(x)) mit einer Vergleichsregel (VR), die gemäß einer Übereinstimmung der Test-Signalverläufe (TSV(x)) mit Vergleichs-Signalverläufen, denen mindestens ein Parameter zugeordnet ist, denjenigen Parameterwert (P(x)) auswählt, der dem Vergleichs-Signalverlauf mit der größten Übereinstimmung mit dem Test-Signalverlauf (TSV(x)) entspricht, und diesen Parameterwert (P(x)) dem Bildpunkt (x) des Test-Signalverlaufs (TSV(x)) zuordnet,
- Vergleichen des zugeordneten Parameterwertes (P(x)) mit Parameterwerten für andere Bildpunkte (x) und/oder mit einem für denselben Bildpunkt (x) in dem Untersuchungsobjekt erwarteten Parameterwert (iP(x)).

10. Verfahren zum Messen von Messdaten eines Untersuchungsobjekts für ein Magnetresonanz-Fingerprinting-Verfahren, umfassend die Schritte:

- Bestimmen einer bevorzugten Reihenfolge von N k-Raumtrajektorien (Traj$_i$), entlang welcher jeweils ein unterabgetasteter Messdatensatz (MDS$_i$) für eine Magnetresonanz-Fingerprinting(MRF)-Messung gemessen werden soll gemäß einem Verfahren nach einem der Ansprüche 1 bis 9
- Messen der Messdaten entlang der k-Raumtrajektorien (Traji) in der bestimmten bevorzugten Reihenfolge (Ord$_b$).

11. Verfahren zum Erstellen von Parameterkarten eines Untersuchungsobjekts mittels Magnetresonanz-Fingerprinting, umfassend die Schritte:

- Messen von Messdaten entlang von k-Raumtrajektorien (Traj$_i$) gemäß Anspruch 10,
- Erstellen mindestens eines gemäß Nyquist unterabgetasteten Messdatensatzes (MDS$_i$) aus entlang der k-Raumtrajektorien (Traj$_i$) gemessener Messdaten,
- Rekonstruieren von Bilddatensätzen (BDS$_i$) aus den unterabgetasteten Messdatensätzen (MDS$_i$),
- Bestimmen mindestens eines Signalverlaufs (SV(x)) mindestens eines Bildpunktes (x) der rekonstruierten Bilddatensätze (BDS$_i$) ,
- Bestimmen mindestens eines Parameters des Untersuchungsobjekts pro Bildpunkt (x) durch Vergleichen der bestimmten Signalverläufe (SV(x)) mit einer Vergleichsregel (VR), die gemäß einer Übereinstimmung der Signalverläufe (SV(x)) mit Vergleichs-Signalverläufen, denen der mindestens eine Parameter zugeordnet ist, denjenigen Parameterwert P(x) auswählt, der dem Vergleichs-Signalverlauf mit der größten Übereinstimmung mit dem bestimmten Signalverlauf (SV(x)) entspricht und diesem dem jeweiligen Bildpunkt (x) zuordnet.

12. Magnetresonanzanlage (1) umfassend, eine Magneteinheit (3), eine Gradienteneinheit (5), eine Hochfrequenzeinheit (7) und eine Steuereinrichtung (9), wobei die Steuereinrichtung (9) eine Hochfrequenz-Sende-/Empfangs-Steuerung (7') und eine Bestimmungseinheit (15) zum Bestimmen von bevorzugten Reihenfolgen (Ord$_k$) sowie eine MRF-Einheit (17) umfasst und dazu ausgebildet ist, ein Verfahren nach einem der Ansprüche 1 bis 11 auf der Magnetresonanzanlage (1) auszuführen.

13. Computerprogrammprodukt, welches ein Programm umfasst und direkt in einen Speicher einer Steuereinrichtung (9) einer Magnetresonanzanlage (1) ladbar ist, mit Programm-Mitteln, um die Schritte des Verfahrens nach einem der Ansprüche 1 bis 11 auszuführen, wenn das Programm in der Steuereinrichtung (9) der Magnetresonanzanlage (1) ausgeführt wird.

14. Elektronisch lesbarer Datenträger mit darauf gespeicherten elektronisch lesbaren Steuerinformationen, welche zumindest ein Computerprogrammprodukt nach Anspruch 13 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 11 durchführen.

**Claims**

1. Computer-implemented method for determining a preferred order of N k-space trajectories (Traj$_i$), along which in each case an undersampled scan data set (MDS$_i$) can be scanned for a magnetic resonance fingerprinting (MRF) scan, comprising the following steps:

- choosing a sampling pattern which comprises N k-space trajectories (Traj$_i$) along which scan data can be recorded in such a way that a scan data set (MDS$_i$) undersampled according to Nyquist can be created from the scan data scanned along at least one of the N k-space trajectories (Traj$_i$), wherein a signal characteristic (SV(x)) of at least one image point (x) reconstructed from the undersampled scan data set (MDS$_i$) can be determined from image points (x) reconstructed from the undersampled scan data sets (MDS$_i$), and one parameter of the examination object (U) can be determined per reconstructed image point (x) from the determined signal characteristics (SV(x)) by comparing the determined signal characteristics (SV(x)) with a comparison rule (VR),
- varying an order (Ord$_k$) in which the N k-space trajectories (Traj$_i$) are to be sampled one after the other, so at least two different orders (Ord$_k$) are produced,
- comparing test signal characteristics (TSV(x)), determined according to the orders (Ord$_k$) resulting due to the variation, with ideal signal characteristics (iSV(x)), wherein the ideal signal characteristics (iSV(x)) are determined from comparison signal characteristics of a dictionary of an MRF method,
- determining a preferred order (Ord$_b$) from the resulting orders (Ord$_k$), with which artifacts in parameter maps determined by means of MRF can be avoided or at least reduced, by taking into account the results of the comparison.

2. Method according to claim 1, wherein test signal characteristics (TSV(x)) for comparing the orders ($Ord_k$) in at least one image point (x) are determined from image data sets ($BDS_i$) reconstructed from undersampled scan data sets scanned in test scans along the N k-space trajectories ($Traj_i$) in the orders ($Ord_k$) that have resulted in each case.

3. Method according to one of the preceding claims, wherein test signal characteristics (TSV(x)) for comparing the orders ($Ord_k$) are determined by means of simulation.

4. Method according to one of the preceding claims, wherein ideal signal characteristics (iSV(x)) are determined from comparison signal characteristics of the dictionary by means of a comparison rule (VR) of an MRF method by comparison with the test signal characteristics (TSV(x)) and/or in the case of known or determinable sought parameter values, by choosing the comparison signal characteristic that best fits the sought parameter values.

5. Method according to one of the preceding claims, wherein comparing the orders ($Ord_k$) comprises the following steps:

   - determining at least one test signal characteristic (TSV(x)) of at least one image point (x),
   - determining ideal signal characteristics (iSV(x)) of the appropriate image points (x) corresponding to the determined test signal characteristics (TSV(x)),
   - forming a differential signal (Diff(t)) of the determined test signal characteristics (TSV(x)) with their corresponding determined ideal signal characteristics (iSV(x)),
   - determining the preferred order ($Ord_b$) on the basis of the formed differential signals.

6. Method according to claim 5, wherein comparison of the orders ($Ord_k$) comprises one frequency analysis of each of the formed differential signals (Diff(o)) considered in a fixed sequence for each resulting order ($Ord_k$), and the preferred order ($Ord_b$) is determined on the basis of the results of the frequency analyses.

7. Method according to claim 6, wherein comparison of the orders ($Ord_k$) comprises a weighting of the results of the frequency analysis in such a way that low frequencies are weighted higher than high frequencies, and a preferred order ($Ord_b$) has an optimally low value for a sum of the weighted results of the frequency analyses.

8. Method according to claim 3, wherein the simulation for each of the N k-space trajectories ($Traj_i$) comprises determining a component of a signal of at least one image point (x), which was in each case reconstructed from a scan data set ($MDS_i$) scanned along one of the k-space trajectories ($Traj_i$), which set should actually be associated with other image points (x).

9. Method according to one of the preceding claims, wherein comparison of the orders ($Ord_k$) comprises the following steps:

   - determining test signal characteristics (TSV(x)) for at least one image point (x),
   - comparing the test signal characteristics (TSV(x)) with a comparison rule (VR), which according to matching of the test signal characteristics (TSV(x)) with comparison signal characteristics, with which at least one parameter is associated, chooses that parameter value (P(x)) which corresponds to the comparison signal characteristic having the best match with the test signal characteristic (TSV(x)), and associates this parameter value (P(x)) with the image point (x) of the test signal characteristic (TSV(x)),
   - comparing the associated parameter value (P(x)) with parameter values for other image points (x) and/or with a parameter value (iP(x)) expected for the same image point (x) in the examination object.

10. Method for scanning scan data of an examination object for a magnetic resonance fingerprinting method, comprising the following steps:

   - determining a preferred order of N k-space trajectories ($Traj_i$) along which in each case an undersampled scan data set ($MDS_i$) is to be scanned for a magnetic resonance fingerprinting (MRF) scan in accordance with a method according to one of claims 1 to 9
   - scanning scan data along k-space trajectories ($Traj_i$) in the preferred order ($Ord_b$).

11. Method for creating parameter maps of an examination object by means of magnetic resonance fingerprinting, comprising the following steps:

- scanning scan data along k-space trajectories (Traj$_i$) according to claim 10,
- creating at least one scan data set (MDS$_i$) undersampled according to Nyquist from scan data scanned along the k-space trajectories (Traj$_i$),
- reconstructing image data sets (BDS$_i$) from the undersampled scan data sets (MDS$_i$),
- determining at least one signal characteristic (SV(x)) of at least one image point (x) of the reconstructed image data sets (BDS$_i$),
- determining at least one parameter of the examination object per image point (x) by comparison of the determined signal characteristics (SV(x)) with a comparison rule (VR) which according to matching of the signal characteristics (SV(x)) with comparison signal characteristics, with which at least one parameter is associated, chooses that parameter value P(x) which corresponds to the comparison signal characteristic having the best match with the determined signal characteristic (SV(x)) and associates this with the respective image point (x).

12. Magnetic resonance system (1) comprising a magnetic unit (3), a gradient unit (5), a high-frequency unit (7) and a control device (9), wherein the control device (9) has a high-frequency transceiver controller (7') and a determining unit (15) for determining preferred orders (Ord$_k$), and an MRF unit (17) and is designed to carry out a method according to one of claims 1 to 11 on the magnetic resonance system (1).

13. Computer program product, which comprises a program and can be loaded directly into a storage device of a control device (9) of a magnetic resonance system (1), having program means in order to carry out the steps of the method according to one of claims 1 to 11 when the program is run in the control device (9) of the magnetic resonance system (1).

14. Electronically readable data carrier having electronically readable control information stored thereon which comprises at least one computer program according to claim 13 and is configured in such a way that it carries out a method according to one of claims 1 to 11 when the data carrier is used in a control device (9) of a magnetic resonance system (1) .

## Revendications

1. Procédé mis en œuvre par ordinateur
de détermination d'une suite préférée de N trajectoires (Traj$_i$) d'espace k, le long desquelles respectivement un ensemble (MDS$_i$) de données de mesure sous-échantillonné peut être mesuré pour une mesure d'empreinte digitale (MRF) par résonance magnétique, comprenant les stades :

- sélection d'un schéma d'échantillonnage, qui comprend N trajectoires (Traj$_i$) d'espace k, le long desquelles des données de mesure peuvent être enregistrées, de manière à pouvoir, à partir des données de mesure mesurées le long d'au moins l'une des N trajectoires (Traj$_i$) d'espace k, établir un ensemble (MDS$_i$) de données de mesure sous-échantillonné suivant Nyquist, dans lequel à partir de points (x) image reconstruits à partir des ensembles (MDS$_i$) de données de mesure sous-échantillonnés, une courbe (SV(x)) de signal d'au moins un point (x) image reconstruit à partir de l'ensemble (MDS$_i$) de données de mesure sous-échantillonné peut être déterminée et, à partir des courbes (SV(x)) de signal déterminées, un paramètre de l'objet (U) en examen peut, par comparaison des courbes (SV(x)) de signal déterminées à une règle (VR) de comparaison, être déterminé par point (x) image reconstruit,
- variation d'une suite (Ord$_k$) , dans laquelle on doit échantillonner les N trajectoires (Traj$_i$) d'espace k les unes après les autres dans le temps, de manière à créer au moins deux suites (Ord$_k$) différentes,
- comparaison de courbes (TSV(x)) de signal de test, déterminées conformément aux suites (Ord$_k$) créées par la variation, à des courbes (iSV(x)) de signal idéales, dans lequel on détermine les courbes (iSV(x)) de signal idéales à partir de courbes de signal de comparaison d'un dictionnaire d'un procédé MRF
- détermination d'une suite (Ord$_b$) préférée parmi les suites (Ord$_k$) créées, par laquelle on peut éviter ou du moins réduire des artéfacts dans des cartes de paramètres, déterminées au moyen de MRF, en tenant compte des résultats de la comparaison.

2. Procédé suivant la revendication 1, dans lequel on détermine des courbes (TSV(x)) de signal de test pour la comparaison des suites (Ord$_k$) dans au moins un point (x) image à partir d'ensembles (BDS$_i$) de données d'image reconstruits à partir d'ensembles de données de mesure sous-échantillonnés mesurés dans des mesures de test le long des N trajectoires (Traj$_i$) d'espace k dans les suites (Ord$_k$) créées respectivement.

3. Procédé suivant l'une des revendications précédentes, dans lequel on détermine des courbes (TSV(x)) de signal de test pour la comparaison des suites (Ord$_k$) au moyen d'une simulation.

4. Procédé suivant l'une des revendications précédentes, dans lequel on détermine les courbes (iSV(x)) de signal idéales à partir de courbes de signal de comparaison du dictionnaire, au moyen d'une règle (VR) de comparaison d'un procédé MRF par comparaison aux courbes (TSV(x)) de signal de test et/ou, pour des valeurs de paramètres recherchées connues ou pouvant être déterminées, par sélection de la courbe de signal de comparaison s'adaptant au mieux aux valeurs de paramètres recherchées.

5. Procédé suivant l'une des revendications précédentes, dans lequel la comparaison des suites (Ord$_k$) comprend les stades suivants :

   - détermination d'au moins une courbe (TSV(x)) de signal de test d'au moins un point (x) image,
   - détermination de courbes (iSV(x)) de signal idéales, correspondant aux courbes (TSV(x)) de signal de test déterminées, des points (x) image correspondant,
   - formation d'un signal (Diff(t)) de différence des courbes (TSV(x)) de signal de test déterminées à leurs courbes (iSV(x)) de signal idéales déterminées correspondantes,
   - détermination de la suite (Ord$_b$) préférée sur la base des signaux de différence formés.

6. Procédé suivant la revendication 5, dans lequel la comparaison des suites (Ord$_k$) comprend respectivement une analyse de fréquence des signaux (Diff(o)) de différence formés, considérés pour chaque suite (Ord$_k$) créée dans un ordre fixe et on détermine la suite (Ord$_b$) préférée sur la base des résultats des analyses de fréquence.

7. Procédé suivant la revendication 6, dans lequel la comparaison des suites (Ord$_k$) comprend une pondération des résultats de l'analyse de fréquence, de manière à pondérer davantage des fréquences basses que des fréquences hautes et une suite (Ord$_b$) préférée a une valeur aussi petite que possible d'une somme des résultats pondérés des analyses de fréquence.

8. Procédé suivant la revendication 3, dans lequel la simulation pour chacune des N trajectoires (Traj$_i$) d'espace k, comprend une détermination d'une proportion d'un signal d'au moins un point (x) image, qui a été reconstruit respectivement à partir d'un ensemble (MDS$_i$) de données de mesure mesuré le long de l'une des trajectoires (Traj$_i$) d'espace k et qui serait à associer en fait à d'autres points (x) image.

9. Procédé suivant l'une des revendications précédentes, dans lequel la comparaison des suites (Ord$_k$) comprend les stades :

   - détermination de courbes (TSV(x)) de signal de test pour au moins un point (x) image,
   - comparaison des courbes (TSV(x)) de signal de test à une règle (VR) de comparaison, qui, conformément à une coïncidence des courbes (TSV(x)) de signal de test avec des courbes de signal de comparaison auxquelles est associé au moins un paramètre, sélectionne la valeur (P(x)) de paramètre, qui correspond à la courbe de signal de comparaison ayant la coïncidence la plus grande avec la courbe (TSV(x)) de signal de test et qui associe cette valeur (P(x)) de paramètre au point (x) image de la courbe (TSV(x)) de signal de test,
   - comparaison de la valeur (P(x)) de paramètre associée à des valeurs de paramètres pour d'autres points (x) image et/ou à une valeur (iP(x)) de paramètre escomptée pour le même point (x) image dans l'objet en examen.

10. Procédé de mesure de données de mesure d'un objet en examen pour un procédé d'empreinte digitale par résonance magnétique, comprenant les stades :

   - détermination d'une suite préférée de N trajectoires (Traj$_i$) d'espace k le long desquelles respectivement un ensemble (MDS$_i$) de données de mesure sous-échantillonnées doit être mesuré pour une mesure d'empreinte digitale (MRF) par résonance magnétique suivant un procédé selon l'une des revendications 1 à 9
   - mesure des données de mesure le long des trajectoires (Traj$_i$) d'espace k dans la suite (Ord$_b$) préférée déterminée.

11. Procédé d'établissement de cartes de paramètres d'un objet en examen, au moyen d'une empreinte digitale par résonance magnétique, comprenant les stades :

- mesure de données de mesure le long de trajectoires (Traj$_i$) d'espace k suivant la revendication 10,
- établissement d'au moins un ensemble (MDS$_i$) de données de mesure sous-échantillonné suivant Nyquist, à partir des données de mesure mesurées le long des trajectoires (Traj$_i$) d'espace k,
- reconstruction d'ensembles (BDS$_i$) de données d'image à partir des ensembles (MDS$_i$) de données de mesure sous-échantillonnés,
- détermination d'au moins une courbe (SV(x)) de signal d'au moins un point (x) image des ensembles (BDS$_i$) de données d'image reconstruits,
- détermination d'au moins un paramètre de l'objet en examen par point (x) image par comparaison des courbes (SV(x)) de signal déterminées à une règle (VR) de comparaison, qui, conformément à une coïncidence des courbes (SV(x)) de signal de test avec des courbes de signal de comparaison auxquelles est associé au moins un paramètre, sélectionne la valeur P(x) de paramètre, qui correspond à la courbe de signal de comparaison ayant la coïncidence la plus grande avec la courbe (SV(x)) de signal de test et qui associe cette valeur de paramètre au point (x) image.

12. Installation (1) de résonance magnétique, comprenant une unité (3) d'aimant, une unité (5) de gradient, une unité (7) de haute fréquence et un dispositif (9) de commande, dans laquelle le dispositif (9) de commande comprend une commande (7') d'émission/réception en haute fréquence et une unité (15) de détermination pour la détermination de suites (Ord$_k$) préférées ainsi qu'une unité (17) MRF et qui est constituée pour exécuter un procédé suivant l'une des revendications 1 à 11 sur l'installation (1) de résonance magnétique.

13. Produit de programme d'ordinateur, qui comprend un programme et qui peut être chargé directement dans la mémoire d'un dispositif (9) de commande d'une installation (1) de résonance magnétique, comprenant des moyens de programme pour exécuter les stades du procédé suivant l'une des revendications 1 à 11, lorsque le programme est exécuté dans le dispositif (9) de commande de l'installation (1) de résonance magnétique.

14. Support de données déchiffrable électroniquement, sur lequel sont mises en mémoire des informations de commande déchiffrables électroniquement, qui comprennent au moins un produit de programme d'ordinateur suivant la revendication 13 et sont conformées de manière à ce que, lorsque le support de données est utilisé dans un dispositif (9) de commande d'une installation (1) de résonance magnétique, elles exécutent un procédé suivant l'une des revendications 1 à 11.

FIG 1

# FIG 2

FIG 3

FIG 4

FIG 5

FIG 6

FIG 7

FIG 8

FIG 9

FIG 10

FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016217675

**In der Beschreibung aufgeführte Nicht-Patentliteratur**

- **TSAO et al.** Lattice Permutation for Reducing Motion Artifacts in Radial and Spiral Dynamic Imaging. *Magn. Reson. Med.,* 2006, vol. 55, 116-125
- **MA et al.** Magnetic Resonance Fingerprinting. *Nature,* 2013, vol. 495, 187-192
- **JIANG et al.** MR Fingerprinting Using Fast Imaging with Steady State Precession (FISP) with Spiral Readout. *Magnetic Resonance in Medicine,* 2015, vol. 74, 1621-1631
- **WANG et al.** Magnetic resonance fingerprinting with compressed sensing and distance metric learning. *Neurocomputing,* 2016, vol. 174, 560-570